(19) Europäisches Patentamt
European Patent Office
Office européen des brevets

(11) **EP 4 223 423 A1**

(12) **EUROPEAN PATENT APPLICATION**

(43) Date of publication:
**09.08.2023 Bulletin 2023/32**

(21) Application number: **22155693.9**

(22) Date of filing: **08.02.2022**

(51) International Patent Classification (IPC):
***B06B 1/06*** *(2006.01)* ***A61B 8/00*** *(2006.01)*
***H01L 41/08*** *(2006.01)*

(52) Cooperative Patent Classification (CPC):
**B06B 1/0648; G01N 29/043; G01N 29/0654;**
**G01N 29/2437; G01N 29/28; H10N 30/00;**
B06B 2201/55; G01N 2291/044

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Nederlandse Organisatie voor**
**toegepast-natuurwetenschappelijk Onderzoek**
**TNO**
**2595 DA 's-Gravenhage (NL)**

(72) Inventors:
• **QUESSON, Benoit André Jacques**
**2595 DA 's-Gravenhage (NL)**
• **VAN NEER, Paul Louis Maria Joseph**
**2595 DA 's-Gravenhage (NL)**
• **VAN RIEL, Martinus Cornelius Johannes Maria**
**2595 DA 's-Gravenhage (NL)**
• **NIEUWKOOP, Evert**
**2595 DA 's-Gravenhage (NL)**

(74) Representative: **V.O.**
**P.O. Box 87930**
**2508 DH Den Haag (NL)**

(54) **ACOUSTIC TRANSDUCER AND DEVICES COMPRISING THE SAME**

(57)    An acoustic transducer (10A), is provided that comprises a piezo-electric layer (11) that is arranged between a first electrode (12) and a second electrode (13) and that has a pair of mutually opposite main surfaces (111, 112). At least one of the first electrode and the second electrode is mechanically decoupled from the main surfaces of the piezo-electric layer. Therewith the acoustic transducer can be driven at substantially higher frequencies. The improved acoustic transducer is particularly suitable for acoustic microscopy applications.

FIG 1A

EP 4 223 423 A1

## Description

The present invention pertains to an acoustic transducer.

The present invention further pertains to devices comprising the same, such as a probe comprising the acoustic transducer and an acoustic microscopy device comprising the acoustic transducer, optionally as part of a probe.

In time lithographic technology has made a strong progress. As predicted by Moore's law this technology has been improved to as to manufacture integrated circuit patterns at an ever increasing density. In the last two decades critical dimensions have been reduced from over 20 nm to less than 5 nm. Another development is that devices are manufactured with an increasing number of layers. For example nowadays 3D V-NAND flash memory devices are manufactured with over 100 device layers.

It is not sufficient that improved patterning technology is available to accomplish the small critical dimensions. It is also necessary that the patterning result can be imaged. Optical microscopy is no longer suitable in these circumstances due to the fact that the features to be observed have a size which is two orders of magnitude below the wavelength of visual optical radiation. Electron beam microscopy is suitable as such to inspect a nano patterned surface, but is a destructive technology. Moreover for manufacturing layered devices it is necessary to provide for an accurate alignment between device layers, for example to achieve proper electrical connections. This requires an imaging technology that not only is capable to image the surface of the product being manufactured, but requires also that layers below the surface can be imaged in order to determine alignment of features in mutually different layers. With electron beam microscopy this is not possible. In this connection it is noted that modern designs typically also include layers of optically opaque materials, such as metals. Hence, even if markers of sufficiently large size were provided for optical detection, such optical markers when present in buried layers could not be imaged with optical methods.

In principal, acoustic microscopy is suitable for imaging product layers below the surface, but what can be achieved is limited by the acoustic frequency. Commercially available acoustic microscopy devices typically operate at an acoustic frequency in the range of 0.05 to 1 GHz. This limits the resolution with which features can be detected to a few micron, e.g. 3 micron for PMMA and 6 micron for SiO2, which is insufficient for imaging in the nanometer range. Whereas the technology allows imaging buried layers, the detection depth is in the range of about 1 micron, which is modest. For a complete image of the product being manufactured it is required that a 3D scan is performed. I.e. the surface is to be scanned and the scan has to be performed at mutually different settings to render it possible to extract imaging data for individual layers.

## SUMMARY

It is an object of the present application to provide an improved acoustic transducer.

It is a further object of the present application to provide a probe comprising the improved acoustic transducer.

It is a still further object of the present application to provide a microscopy device comprising the improved acoustic transducer, optionally as part of a probe.

In accordance with the first-mentioned object embodiments of an improved acoustic transducer comprise a piezo-electric layer that is arranged between a first electrode and a second electrode, the piezo-electric layer has a pair of mutually opposite main surfaces. At least one of the first electrode and the second electrode is mechanically decoupled from the main surfaces of the piezo-electric layer. In operation the electrodes are connected with a voltage source to provide a high frequent AC voltage between the electrodes. Although only the voltage difference between the electrodes is relevant for its operation, the voltage of one of the electrodes may be fixed at a 0, e.g. the mass potential. Due to this mechanical decoupling a resonance frequency of the piezo-electric layer can be substantially higher than that which can be achieved in case both cases are mechanically coupled to the piezo-electric layer. The higher resonance frequency renders it possible to perform acoustic imaging at a substantially finer detail than would be the case when a conventional acoustic transducer is used, wherein both electrodes are mechanically coupled to the piezo-electric layer.

In some embodiments of the improved acoustic transducer, the piezo-electric material is polled laterally. In an example of these embodiments of the improved acoustic transducer are used as shear wave transducers.

In some embodiments of the improved acoustic transducer, the first electrode and the second electrode are arranged at laterally opposite sides of the piezo-electric layer. Due to the fact that the surface area of the laterally opposite sides of the main surfaces of the piezo electric layer are not in contact with the main surfaces of the piezo-electric layer, it is achieved that effectively both electrodes are mechanically decoupled from the piezo-electric main layers. In an example the improved acoustic transducer having the electrodes at laterally opposite sides of the piezo-electric layer is used in a configuration where vibrations of the piezo-electric layer in thickness mode in the lateral direction are converted to a vertical thickness mode vibration by mass conservation.

In other embodiments of the improved acoustic transducer a first main surface of the pair of mutually opposite main surfaces faces the first electrode and a second main surface of the pair of mutually opposite main surfaces faces the second electrode. As the first electrode mechanically couples the piezo electric layer to the substrate, the first electrode in this embodiment is preferably kept at or near mass potential for safety reasons.

Therewith the second electrode is the "hot electrode". In this embodiment the second main surface and the second electrode are mechanically decoupled. Mechanically decoupling the second main surface from the second electrode can be achieved in various ways.

In exemplary embodiments the second main surface and the second electrode are mechanically decoupled by a gap. In some examples thereof, the gap is evacuated. That is the space formed by the gap is substantially free from any medium by evacuation thereof. The vacuum achieved therewith may be a low vacuum of about 100 to 300.000 Pa, a medium vacuum of about 0.1 to 100 Pa , or even a high vacuum of less than 0.1 Pa.

In other examples the gap is filled with a gas, e.g. an inert gas or a mixture thereof, e.g. air. In other examples the gap is filled with a liquid. Therewith it is presumed that the liquid can freely flow in/out the space to minimize acoustic damping.

In the examples previously mentioned the gap provides for a capacitive coupling between the second electrode and the second main surface of the piezo electric layer. Therewith, as compared to a conventional acoustic transducer, wherein both electrodes are attached to the main surfaces of the piezo electric layer, the voltage difference over piezo electric layer is attenuated by an attenuation factor A as follows.

$$A = \frac{U_g}{U_p} = \frac{C_a + C_p}{C_a} = \frac{\varepsilon_a \cdot d_p + \varepsilon_p \cdot d_a}{\varepsilon_a \cdot d_p}$$

Therein $U_g$ is the voltage between the electrodes, also denoted as excitation voltage, $U_p$ is the voltage across the piezo electric layer, $\varepsilon_a$ is the relative dielectric constant of the medium in the gap. In the absence of a medium, the evacuated case, $\varepsilon_a = 1$. Also for air in normal atmospheric conditions the relative dielectric constant $\varepsilon_a$ is about 1. $\varepsilon_p$ is the relative dielectric constant of the material of the piezo electric layer. The symbols $d_a$, $d_p$ respectively are the thickness of the gap and the thickness of the piezo electric layer. The capacitance of the airgap and the capacitance of the piezo electric layer are respectively indicated with $C_a$, $C_p$.

The attenuation factor A may be minimized with the one or more of the following approaches.

Decrease the gap $d_a$ or increasing the piezo thickness $d_p$.

Selecting a piezo electric material with a lower relative dielectric constant.

It has been contemplated to provide the gap with a filling of a gas having a relative dielectric constant higher that of air. However all gasses, as far as known, have a dielectric constant just above 1, but not substantially higher. Instead, a fluid or a solid material having a high rel. dielectric constant and a low young modulus are suitable for this purpose. Examples are a composite comprising a silicone based material like PDMS laced with another material, e.g. ceramic particles, which has a relative dielectric constant in the order of 3-4 and a Youngs modulus of 0.25-0.31 MPa. Acrylate laced with conductive nanofillers is mentioned as another example.

According to another approach the gap is filled with an electrically conductive foam. Therewith a direct electrical connection is provided between the second electrode and the second main surface of the piezo electric layer, while avoiding a significant mechanical coupling therebetween. Examples thereof are a filling with a foam comprising buckminsterfullerene, carbon nanotubes or graphene. In particular buckminsterfullerene, also denoted as buckyballs, is favorable in view of its high conductivity.

According to a still further approach, the gap has a breakdown voltage that is less than a breakdown voltage of the piezo-electric layer. This renders possible an application, wherein the electrodes of the acoustic transducer are connected to a voltage source that drives the acoustic transducer with a drive voltage having a magnitude that is higher than the breakdown voltage of the gap and that is lower than the breakdown voltage of the piezo-electric layer. In that case the voltage on the second main surface of the piezo electric layer will follow the voltage on the second electrode. In this way the voltage difference between the main surfaces of the piezo electric layer is lowered with the breakdown voltage, in contrast to embodiments in the absence of breakdown, wherein the voltage difference is equal to the voltage difference between the electrodes divided by the attenuation factor A. The breakdown voltage can be modest provided that the gap size is not too large, e.g. less than a few micron, e.g. in the order of 100 nm.

The acoustic transducer is particularly suitable for use in a probe for an inspection device. The probe comprises a carrier having a first surface provided with an acoustic coupling element and a second surface, opposite the acoustic coupling element is provided with an embodiment of the improved acoustic transducer. The carrier is for example a flexible carrier, such as a cantilever or a membrane and the acoustic coupling element on the first surface thereof is for example a tip. Alternatively, the carrier can be provided as a rigid material, as further discussed below in an example.

Various options are available for electrically connecting the electrodes with an AC-voltage source. In one example the second electrode is provided with an electrically insulating layer at a surface facing the piezo electric layer . The electrically insulating layer is for example an electrically insulating adhesive material. In this case a carrier supporting the acoustic transducer may be electrically conductive an provide the electrical connection to the first electrode, or form a first electrode itself. A separate electrical connection needs to be provided for the second electrode. According to another option the first electrode is electrically connected to an electric connector arranged below the surface of the substrate. In this case the substrate may serve as an electric conductor to the second electrode.

An acoustic microscopy device for imaging as provided herein comprises a probe with an improved acoustic transducer as provided herein. The acoustic microscopy device also comprises a carrier for carrying a sample, for example a semi-finished semiconductor product, to be imaged. The acoustic microscopy device further comprises a signal generator that in operation generates a high frequency drive signal, for example a drive signal having a frequency in the order of a few tens to a few hundreds GHz. In operation the acoustic transducer of the probe generates in response to said drive signal an ultrasound acoustic input signal that has at least one acoustic input signal component and an acoustic coupling element transmits the acoustic input signal as an acoustic wave into the sample carried by the carrier. The probe further comprising a sensor facility to provide a sensor signal that is indicative for an acoustic signal resulting from reflections of the acoustic wave within the sample. The acoustic microscopy device further comprises a signal processor to generate an image signal in response to the sensor signal.

In one example of the improved imaging device, the acoustic coupling element is a tip, and the imaging device further comprises a scanning mechanism to provide for a relative displacement between the sample and the probe, along a surface of the sample. The sensed acoustic signal in particular provides information about the location where the tip is positioned. A single scanning position mainly provides information about the sample at the position where the tip is positioned. The scanning mechanism in operation provides for a relative displacement between the sample and the probe so that therewith information about a volume within the scanning area of the sample can be obtained.

In another example the acoustic coupling element is an acoustic coupling layer arranged between the probe and the sample and the first electrode of the acoustic transducer comprises a plurality of mutually insulated electrode segments that are laterally distributed on the first main surface of the piezo-electric layer and/or wherein the second electrode of the acoustic transducer comprises a plurality of mutually insulated electrode segments that are laterally distributed on a carrier surface of a support. In this arrangement scanning of the sample is not necessary. Due to the presence of the coupling layer, the carrier of the probe can be rigid. The patterned electrode(s) in this embodiment render it possible to generate a controlled acoustic wavefront so that the sample below the scan area of the transducer can be imaged without needing a relative displacement of the probe and the sample. Nevertheless, should the sample have a surface area exceeding that of the transducer, the imaging device in this example may additionally be provided with a scanning mechanism to therewith scan each time a new scan area.

In case the sample to be imaged comprises a plurality of layers the received signal is composed of signal contributions originating from each of the layers. According to one option a frequency of the acoustic signal is varied for example in a frequency sweep, so as to change the relative contribution of the various layers in the sensed signal, so that the individual contributions of the layers can be determined. In practice, imaging is repeated each time a new layer is applied, so that information about lower layers is already available, and apart from imaging the uppermost layer, only the alignment of the uppermost layer with the immediately lower layer has to be determined.

It is noted an acoustic transducer as specified in the embodiments above may include additional layers, for example for the purpose of providing electrical insulation or improving inter-layer adhesion. In practice a thickness of such additional layers can be modest, so that they do not significantly affect the acoustical properties of the acoustic transducer.

The present application further provides an improved method of generating an ultrasound acoustic wave that comprises the following:

Providing a piezo-electric layer that has a pair of mutually opposite main surfaces;
Arranging the piezo-electric layer between a first electrode and a second electrode, such that at least one of the first electrode and the second electrode is mechanically decoupled from the main surfaces of the piezo-electric layer;
Applying an AC-voltage between the electrodes having a frequency corresponding to the frequency of the ultrasound acoustic wave to be generated.

The AC-voltage to be applied is for example provided as a sine signal, but this is not necessary. Depending on the application also other waveforms can be applied such as short pulses (corresponding to a broadband signal) or chirps (involving a frequency sweep).

In an embodiment of the improved method the piezo-electric layer is arranged with a first main surface of the pair of mutually opposite main surfaces facing the first electrode and with a second main surface of the pair of mutually opposite main surfaces facing the second electrode. Therewith the second main surface and the second electrode are kept mechanically decoupled from each other by a gap.

As specified above, the gap may be evacuated, but alternatively the gap may be filled with e.g. a liquid or a gas.

In an embodiment a breakdown voltage of the gap is less than a breakdown voltage of the piezo-electric layer.

This renders possible a mode of operation wherein the applied voltage has a voltage value Vd) that exceeds the breakdown voltage of the gap and that is less than the breakdown voltage of the piezo-electric layer. In this case a capacitive voltage drop that would occur in the absence of breakdown is avoided.

BRIEF DESCRIPTION OF THE DRAWINGS

These and other aspects are described in more detail with reference to the drawing. Therein:

FIG. 1A shows a first embodiment of the improved transducer;
FIG. 1B shows a second embodiment of the improved transducer;
FIG. 1C shows a third embodiment of the improved transducer;
FIG. 2A shows a fourth embodiment of the improved transducer;
FIG. 2B shows a fifth embodiment of the improved transducer;
FIG. 2C shows a sixth embodiment of the improved transducer;
FIG. 3A shows a seventh embodiment of the improved transducer;
FIG. 3B shows a eighth embodiment of the improved transducer;
FIG. 4 shows a ninth embodiment of the improved transducer;
FIG. 5 shows an acoustic sound generator comprising an embodiment of the improved transducer;
FIG. 6 shows an embodiment of an acoustic microscopy device having an embodiment of the improved transducer;
FIG. 6A shows a portion of the acoustic microscopy device with the embodiment of the improved transducer therein in more detail;
FIG. 6B shows a portion of another acoustic microscopy device with an embodiment of the improved transducer therein in more detail;
FIG. 7A, 7B and 7C show results of a simulation in which a comparison is made between three configurations.

DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.
Like reference symbols in the various drawings indicate like elements unless otherwise indicated.

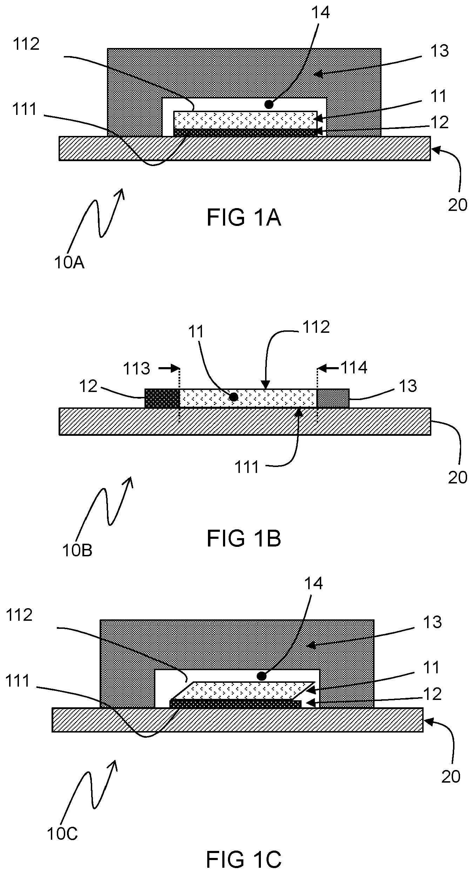

FIG. 1A, FIG. 1B and FIG. 1C show three examples of an improved acoustic transducer. As shown therein, an improved acoustic transducer as disclosed herein comprises a piezo-electric layer 11 that is arranged between a first electrode 12 and a second electrode 13. The piezo-electric layer 11 has a pair of mutually opposite main surfaces 111, 112 and at least one of the electrodes is mechanically decoupled from the main surfaces of the piezo-electric layer.
In the example of the acoustic transducer 10A shown in FIG. 1A, a first main surface 111 of the pair of mutually opposite main surfaces faces the first electrode 12 and a second main surface 112 of the pair of mutually opposite main surfaces faces the second electrode 13. As can be seen in FIG. 1A, in this example the second main surface 112 and the second electrode 13 are mechanically decoupled in that a gap 14 is present between them. In some embodiments the gap 14 is filled with air. This is favorable for manufacturing purposes, as it requires no additional manufacturing steps. In other examples the gap is filled with an inert gas, like a noble gas or nitrogen, or it is evacuation at least to the level of a low vacuum, i.e. the pressure is reduced to below 300 kPa.
In the example of the acoustic transducer 10B as shown in FIG. 1B, the first electrode 12 and the second electrode 13 are arranged at laterally opposite sides 113, 114 of the piezo-electric layer 11.
FIG. 1C schematically shows an embodiment of an acoustic shearwave transducer 10C. Therein the piezo electric layer 11 is laterally polled, so that an AC-electric voltage applied between the electrodes, 12, 13 results in an a lateral acoustic vibration of the piezo-electric layer 11, with which the transducer 10C introduces a shearwave in a sample to be investigated.

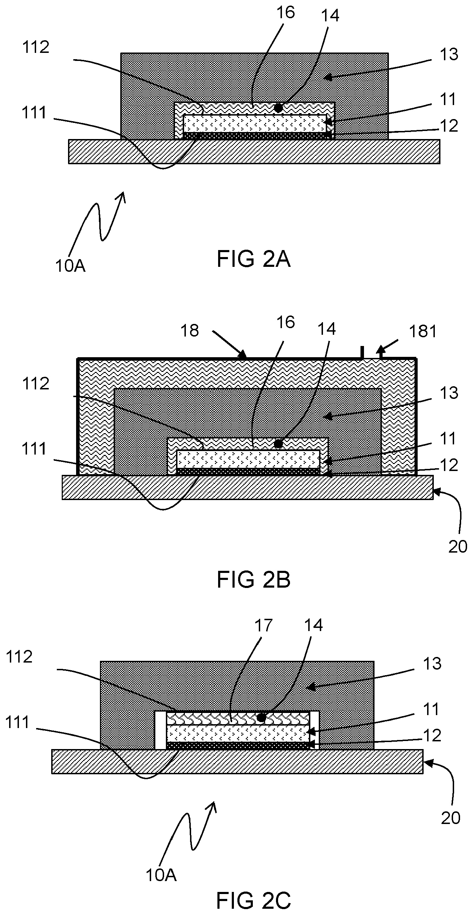

FIG. 2A, 2B, 2C show three other examples of an improved acoustic transducer. The improved acoustic transducer in the examples of FIG. 2A, 2B differ from the example in FIG. 1A in that the gap 14 is filled with a liquid 16, e.g. water. In the embodiment shown in FIG. 2B, the acoustic transducer is accommodated in a liquid-proof container 18. A liquid level therein is controllable by a gap 181 formed in the liquid-proof container 18 for example via a micro-fluidic tube.
In the example of the improved acoustic transducer of FIG. 2C the gap 14 is filled with an electrically conductive foam 17. Therewith a direct electrical connection is provided between the second electrode 13 and the second main surface of the piezo electric layer 11. This avoids that the voltage between the main surfaces of the piezo electric layer 11 is attenuated as is the case with a capacitive coupling, whereas the foam at least significantly decouples the second electrode 13 from the second main surface of the piezo electric layer 11 in a mechanical sense. Exemplary foams for this purpose comprises one or more of buckminsterfullerene, carbon nanotubes or graphene. In particular buckminsterfullerene, also denoted as buckyballs, is favorable in view of its high conductivity.
In the examples shown in FIG. 1A, 1C, 2A, 2B and 2C, the second electrode 13 is directly arranged on the substrate 20, for example in applications wherein the substrate is of a non-conductive material or wherein the substrate has an upper conductive layer to be connected to the second electrode 13.

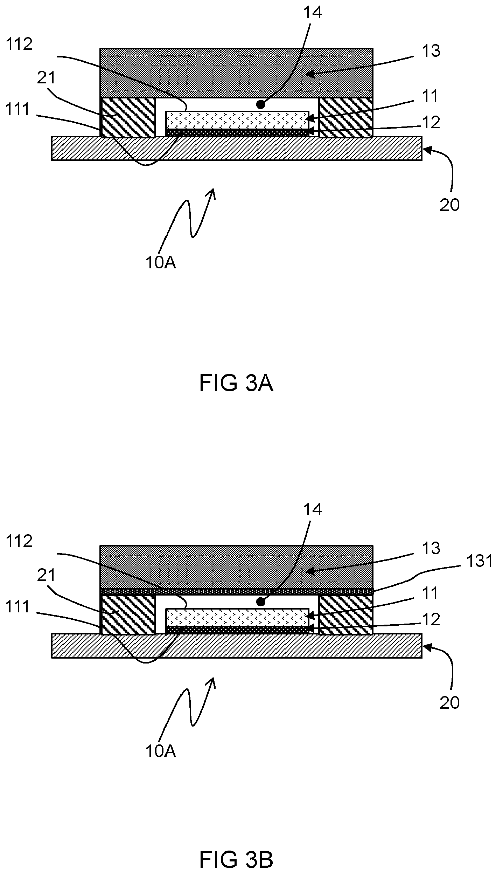

FIG. 3A, 3B shows two embodiments wherein the second electrode 13 is specifically electrically insulated from the substrate 20. In the examples of FIG. 3A, 3B the second electrode 13 is adhered to the substrate 20 with an electrically insulating adhesive material 21. In the example of FIG. 3B, the second electrode 13 is further provided with an electrically insulating layer 131 at a side facing the piezo electric layer 11. It is noted that the gap 14 in the embodiments of FIG. 3A, 3B may be provided with a gas, a liquid or a foam. In the example of FIG. 3A, an electrically conductive foam may be used to electrically connect the second main surface 112 of the piezo electric layer 11 with the second electrode 13.

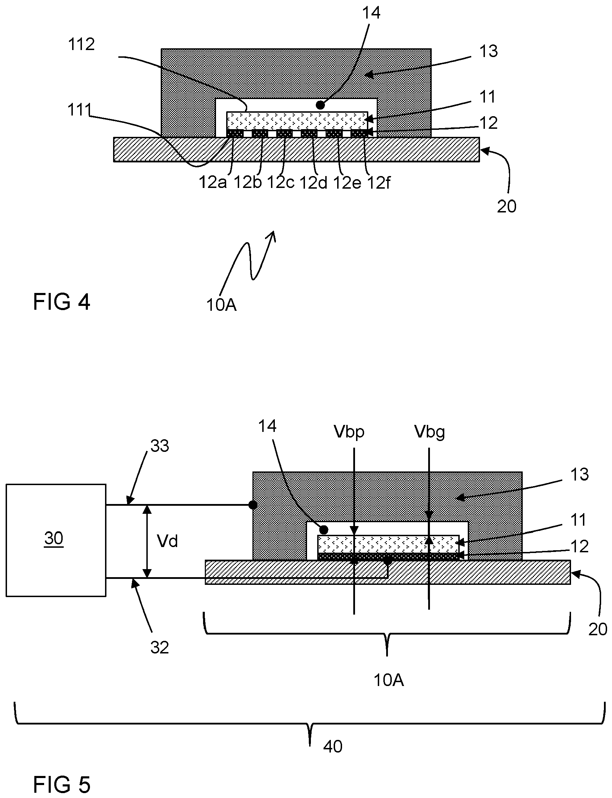

FIG. 4A, 4B show alternative options for providing an electrical connection of the first electrode 12 with an external electric contact for connection to a power supply. In the example of FIG. 4A, the first electrode 12 is provided on top of a conductive layer 32. The electrically conductive layer 32 that further extends on the surface of a substrate 20 can serve as an electric connection to a power supply. In a variation of this example the first electrode 12 is a portion of the electrically conductive layer 32 in contact with the piezo electric layer 11.

In the example of FIG. 4B the first electrode 12 is electrically connected to an electric connector 32a arranged below the surface of the substrate 20.

The options shown in FIG. 4B for electrically connecting the first electrode 12 is also applicable in any of the embodiments shown in FIG. 1A, 2A, 2B, 3A and 3B. In the embodiment shown in 4A, the second electrode 13 may be further provided with an electrically insulating layer 131 at a side facing the piezo electric layer 11 as is illustrated in FIG. 3B.

FIG. 4 shows an example of an improved acoustic transducer 10A wherein the first electrode 12 comprises a plurality of mutually insulated electrode segments 12a,...,12f that are laterally distributed on the first main surface 111 of the piezo-electric layer 11. The insulated electrode segments 12a,...,12f may be provided for example as a sequence of strips or as a matrix of pixels. This renders it possible to provide a controlled acoustic wavefront.

Alternatively, it may be the second electrode 13 that is partitioned into a plurality of mutually insulated electrode segments. In that case the electrode segments can be provided on a carrier surface that faces the piezo electric layer 11 of a support of an insulating material.

It is still further possible that both the first electrode 12 and the second electrode 13 are partitioned. For example the first electrode 12 is partitioned into electrode lines in a first lateral direction, and the second electrode 13 is partitioned into electrode lines in a second lateral direction orthogonal to the first lateral direction. In another example of that combination the first electrode 12 and the second electrode 13 are each partitioned into a matrix of electrode pixels, wherein respective electrode pixels of the first electrode 12 are arranged opposite to respective electrode pixels of the second electrode 13.

FIG. 5 shows an embodiment of an ultrasound generator 40 that comprises an embodiment of the improved acoustic transducer 10A wherein the gap 14 has a breakdown voltage Vbg that is less than a breakdown voltage Vbp of the piezo-electric layer. As shown in FIG. 5, the electrodes 12, 13 of the piezo electric transducer 10A are electrically connected to voltage source 30 with electrical connections 32, 33. In operation the voltage source 30 drives the acoustic transducer 10A with a drive voltage Vd that has a magnitude higher than the breakdown voltage Vbg of the gap 14 and that is lower than the breakdown voltage Vbp of the piezo-electric layer 11. Therewith, in operation it is avoided that the voltage between the main surfaces of the piezo electric layer 11 is attenuated by a capacitive coupling, while the gap provides for a mechanical decoupling of the piezo electric layer and the second electrode.

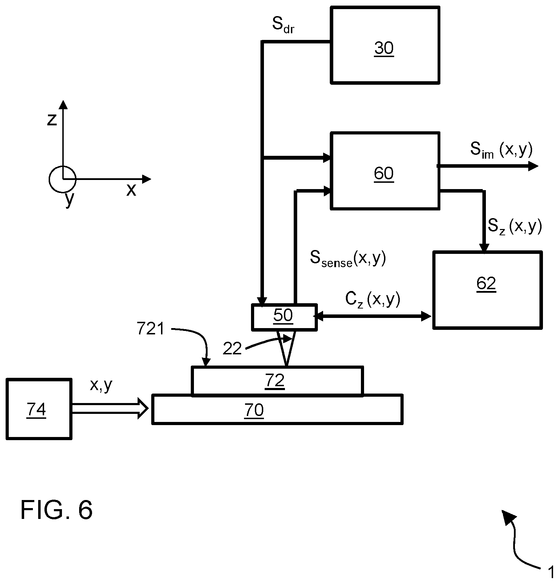

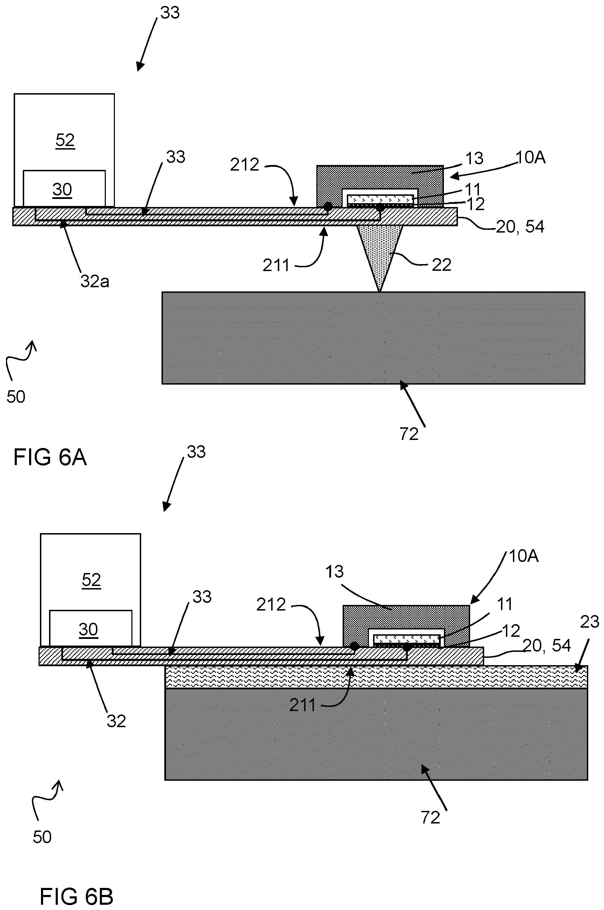

FIG. 6 shows an embodiment of an acoustic microscopy device having an embodiment of the improved transducer. The acoustic microscopy device is an imaging device that comprises a carrier 70, a signal generator 30, a probe 50, and a signal processor 60.

The carrier 70 is configured to carry a sample 72, for example a (semi-finished) component comprising one or more patterned layers. The (semi-finished) component is for example a semi-conductor component comprising electronic features, an optical component comprising optical features, or a hybrid component comprising both electronic and optic features.

The probe 50 comprises an improved acoustic transducer (10A, see FIG. 6A, 6B), for example according to an embodiment as described in more detail with reference to FIG. 1A, 1B, 1C, 2A, 2B, 2C, 3A, 3B, or FIG. 4. The improved acoustic transducer is configured to generate in response to a drive signal generated by the signal generator 30 an ultrasound acoustic input signal having at least one acoustic input signal component. The probe comprises an acoustic coupling element, here a tip 22 on a cantilever (forming a substrate 20, see FIG. 6A), to transmit the acoustic input signal as an acoustic wave into the sample 72. The probe 50 further comprises a sensor facility to provide a sensor signal (Ssense(x,y)) that is indicative for an acoustic signal resulting from reflections of the acoustic wave within the sample 72 sensed at the current position (x, y) of the tip 22. In some examples the improved acoustic transducer 10A additionally serves as the sensor facility that provides the sensor signal. In other examples an acoustic sensor is provided other than the improved acoustic transducer 10A that is used for generating the ultrasound acoustic input signal. The signal processor 60 is configured to generate an image signal (Sim (x,y)) in response to the sensor signal. The imaging device in this example further comprises a scanning mechanism 74 to provide for a relative displacement between the sample 72 and the probe 50, along a surface 721 of the sample 72. In the example shown, the scanning mechanism 74 displaces the sample in the x,y plane, for example in a meandering pattern, so as to cover a target area on the surface of the sample. Alternatively the scanning mechanism could displace the probe 50 while holding the sample in a fixed position. For each position (x,y). The imaging device 1 in this example further comprises a z-level controller 62. Based on an output signal Sz (x,y) from the signal processor 60 it controls a vertical position (in the direction z transverse to the plane x,y) of the tip with respect to the sample surface 721 with control signal Cz (x,y).

FIG. 6A shows a portion of the acoustic microscopy device 1 with the embodiment of the improved transducer therein in more detail. As shown therein, in this example the substrate 20 forms a flexible carrier 54, here in the form of a cantilever. The flexible carrier 54 has a first surface 211 that is provided with the tip 22, serving as acoustic coupling element and it has a second surface 212, opposite the tip that is provided with the embodiment of the improved acoustic transducer 10A. In operation, the ultrasound acoustic input signal generated by the improved acoustic transducer 10A is transmitted as an acoustic wave into the sample 72, and the sensor facility (for example also the improved acoustic transducer 10A) provides the sensor signal (Ssense(x,y)) that is indicative for an acoustic signal resulting from reflections of the acoustic wave within the sample 72.

FIG. 6B shows a portion of another acoustic microscopy device with an embodiment of the improved transducer therein in more detail. In this example, the acoustic coupling element is an acoustic coupling layer 23 arranged between the probe and the sample. Furthermore, the first electrode 12 of the acoustic transducer comprises a plurality of mutually insulated electrode segments 12a,...,12f that are laterally distributed on the first main surface 111 of the piezo-electric layer 11 as shown in FIG. 4. The partitioned electrode 12 renders it possible to generate a controlled acoustic wavefront so that it is possible to image a section of the sample rather than a position at one time. In an alternative example, this is achieved in that the second electrode 13 of the acoustic transducer comprises a plurality of mutually insulated electrode segments (not shown) that are laterally distributed on a carrier surface of a support. In a still further example this is achieved in that both the first electrode 12 and the second electrode 13 are partitioned.

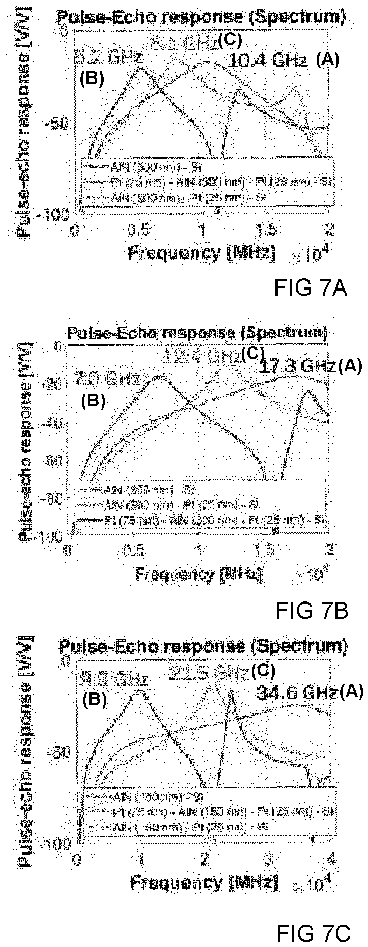

FIG. 7A, 7B and 7C show results of a simulation in which a comparison is made between three configurations.

A: a piezo electric layer of AIN on a silicon layer modeled as having an infinite thickness

B: a stack on the silicon layer and the stack comprises the piezo electric layer having a first electrode with a thickness of 25 nm at the side of the silicon layer, and having second electrode with a thickness of 75 nm at the side facing away from the silicon layer. This is comparable with the conventional arrangement for a transducer.

C: a stack on the silicon layer and the stack comprises the piezo electric layer having only the first electrode with a thickness of 25 nm at the side of the silicon layer. This is comparable with the arrangement of the improved transducer, wherein the second electrode is at distance from the surface of the piezo electric layer facing away from the substrate. Therewith the second electrode does not affect the mechanical behavior of the piezo electric layer.

FIG. 7A shows a comparison of the results for configurations A, B, C in the case that the piezo electric layer has a thickness of 500 nm. It can be seen that for this case the resonance frequency increases from 5.2 GHz for the conventional arrangement to 8.1 GHz for the arrangement used in the improved acoustic transducer. In the case shown in FIG. 7B, the piezo electric layer has a thickness of 300 nm and the resonance frequency increases from 7 GHz for the conventional arrangement to 12.4 GHz for the arrangement used in the improved acoustic transducer. Still further in the example in FIG. 7C the piezo electric layer has a thickness of 150 nm and the resonance frequency increases from 9.9 GHz for the conventional arrangement to 21.5 GHz for the arrangement used in the improved acoustic transducer.

As discussed with reference to FIG. 5, a voltage attenuation due to a capacitive coupling can be avoided if the gap 14 formed between the second electrode and the piezo electric layer 11 has a breakdown voltage $V_{bg}$ that is less than a breakdown voltage $V_{bp}$ of the piezo-electric layer and if the transducer is driven with a drive voltage $V_d$ having a magnitude that is higher than the breakdown voltage $V_{bg}$ of the gap 14 and that is lower than the breakdown voltage $V_{bp}$ of the piezo-electric layer 11. Although there is a voltage drop in the gap necessary to maintain the breakdown condition, this voltage drop can be modest, as is demonstrated by experiments published by Semnani et al, in their manuscript "Frequency response of atmospheric pressure gas breakdown in micro/nanogaps" August 2013, Applied Physics Letters 103(6) DOI:10.1063/1.4817978. Semnani et al showed that for frequencies above about 10 GHz, the breakdown voltage drops to about 30 V for a gap of 2 micron and less. For lower frequencies a breakdown voltage of this order of magnitude can also be achieved, provided that the gap is sufficiently small, e.g. less than 0.5 micron.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

**Claims**

1.  An acoustic transducer (10A, 10B), comprising:
    A piezo-electric layer (11) arranged between a first electrode (12) and a second electrode (13), the piezo-electric layer having a pair of mutually opposite main surfaces (111, 112), **characterized in that** at least one of the first electrode and the second electrode is mechanically decoupled from the main surfaces of the piezo-electric layer.

2. The acoustic transducer (10A) according to claim 1, wherein a first main surface (111) of the pair of mutually opposite main surfaces faces the first electrode (12) and a second main surface (112) of the pair of mutually opposite main surfaces faces the second electrode (13), wherein the second main surface (112) and the second electrode (13) are mechanically decoupled.

3. The acoustic transducer (10A) according to claim 2, wherein the second main surface (112) and the second electrode (13) are mechanically decoupled by a gap (14).

4. The acoustic transducer (10A) according to claim 3, wherein the gap (14) is evacuated.

5. The acoustic transducer (10A) according to claim 3, wherein the gap (14) is filled with a gas or a mixture thereof.

6. The acoustic transducer (10A) according to claim 3, wherein the gap (14) is filled with a liquid (16).

7. The acoustic transducer (10A) according to claim 3, wherein the gap (14) is filled with an electrically conductive foam (17).

8. The acoustic transducer (10A) according to either of the claims 2 to 7, wherein the first electrode (12) comprises a plurality of mutually insulated electrode segments (12a,...,12f) that are laterally distributed on the first main surface (111) of the piezo-electric layer (11) and/or wherein the second electrode (13) comprises a plurality of mutually insulated electrode segments that are laterally distributed on a carrier surface of a support.

9. An ultrasound generator (40) comprising an acoustic transducer (10A) according to either of the preceding claim and further comprising a voltage source (30) configured to drive the acoustic transducer (10) with an AC drive voltage (Vd).

10. The acoustic transducer (10A) according to either of the claims 3 - 8, wherein the gap (14) has a breakdown voltage (Vbg) that is less than a breakdown voltage (Vbp) of the piezo-electric layer.

11. An ultrasound generator (40) comprising an acoustic transducer (10A) according to the preceding claim and further comprising a voltage source (30) configured to drive the acoustic transducer (10) with a drive voltage (Vd) having a magnitude that is higher than the breakdown voltage (Vbg) of the gap (14) and that is lower than the breakdown voltage (Vbp) of the piezo-electric layer (11).

12. An inspection device comprising the ultrasound generator of claim 9 or 11, and further comprising a signal processor to process a sense signal issued by the acoustic transducer in response to a sensed external acoustic signal.

13. A probe (50) for an inspection device comprising a flexible carrier (20) having a first surface (211) provided with an acoustic coupling element (22, 23) and a second surface (212), opposite the acoustic coupling element, provided with the acoustic transducer (10) according to either of the claims 1-8 or 10.

14. An imaging device (1) comprising

    - a carrier (70) for carrying a sample (72);
    - a signal generator (30) to generate a drive signal ($S_{dr}$);
    - a probe (50) according to claim 13 configured to generate in response to said drive signal an ultrasound acoustic input signal having at least one acoustic input signal component and an acoustic coupling element (22) to transmit the acoustic input signal as an acoustic wave into the sample, the probe (50) further comprising a sensor facility to provide a sensor signal ($S_{sense}$) that is indicative for an acoustic signal resulting from reflections of the acoustic wave within the sample (72);
    - a signal processor (60) to generate an image signal (Sim) in response to the sensor signal.

15. Method of generating an ultrasound acoustic wave comprising:

    Providing a piezo-electric layer (11) that has a pair of mutually opposite main surfaces (111, 112);
    Arranging the piezo-electric layer (11) between a first electrode (12) and a second electrode (13), such that at least one of the first electrode and the second electrode is mechanically decoupled from the main surfaces of the piezo-electric layer;
    Applying an AC-voltage between the electrodes having a frequency corresponding to the frequency of the ultrasound acoustic wave to be generated.

FIG 1A

FIG 1B

FIG 1C

16   14

112                                          13
                                             11
111                                          12

10A

FIG 2A

18        16    14        181

112                                          13
                                             11
111                                          12

20

FIG 2B

17    14

112                                          13
                                             11
111                                          12

20

10A

FIG 2C

FIG 3A

FIG 3B

112

14

13

111

11

12

20

12a 12b 12c 12d 12e 12f

FIG 4

10A

33

14    Vbp    Vbg

13

30

11

12

Vd

20

32

10A

40

FIG 5

FIG. 6

FIG 6A

FIG 6B

FIG 7A

FIG 7B

FIG 7C

Europäisches
Patentamt

European
Patent Office

Office européen
des brevets

# EUROPEAN SEARCH REPORT

Application Number

EP 22 15 5693

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 701 659 A (FUJII TADASHI [JP] ET AL) 20 October 1987 (1987-10-20) | 1-3,6,7, 9,10,15 | INV. B06B1/06 |
| Y | * column 7, line 11 - line 31 * | 8 | A61B8/00 |
| A | * column 2, line 6 - line 26 * | 4,5, | H01L41/08 |
|  | * figures 2A, 2B * | 11-14 | |
|  | ----- | | |
| X | WO 2017/186781 A1 (KONINKLIJKE PHILIPS NV [NL]) 2 November 2017 (2017-11-02) | 1,9, 12-15 | |
| A | * page 2, line 14 - line 17 * | 2-8,10, | |
|  | * page 11, line 26 - page 12, line 3 * | 11 | |
|  | * page 18, line 22 - line 29 * | | |
|  | * page 24, line 10 - page 26, line 9 * | | |
|  | ----- | | |
| X | DANTE ALEX ET AL: "Optical high-voltage sensor based on fiber Bragg gratings and stacked piezoelectric actuators for ac measurements", APPLIED OPTICS, [Online] vol. 58, no. 30, 20 October 2019 (2019-10-20), pages 8322-8330, XP055934437, US ISSN: 1559-128X, DOI: 10.1364/AO.58.008322 Retrieved from the Internet: URL:https://opg.optica.org/DirectPDFAccess /AD93402A-E19F-4478-920985BBFD90F27E_42242 7/ao-58-30-8322.pdf?da=1&id=422427&seq=0&m obile=no> [retrieved on 2022-06-22] | 1,9,15 | TECHNICAL FIELDS SEARCHED (IPC) B06B H01L A61B H02N |
| A | * figure 5 * | 2-8, 10-14 | |
|  | ----- | | |
| Y | US 4 510 411 A (HAKAMATA KAZUO [JP] ET AL) 9 April 1985 (1985-04-09) * column 5, line 37 - column 6, line 7 * | 8 | |
|  | ----- | | |

The present search report has been drawn up for all claims

| Place of search | Date of completion of the search | Examiner |
|---|---|---|
| The Hague | 27 June 2022 | Hippchen, Sabine |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 15 5693

This annex lists the patent family members relating to the patent documents cited in  the above-mentioned European search report.
The members are as contained in the European Patent Office EDP file on
The European Patent Office is in no way liable for these particulars which are merely given for the purpose of information.

27-06-2022

| Patent document cited in search report | | Publication date | Patent family member(s) | | Publication date |
|---|---|---|---|---|---|
| US 4701659 | A | 20-10-1987 | EP | 0176030 A2 | 02-04-1986 |
| | | | US | 4701659 A | 20-10-1987 |
| | | | US | 4783888 A | 15-11-1988 |
| WO 2017186781 | A1 | 02-11-2017 | CN | 109069107 A | 21-12-2018 |
| | | | EP | 3448261 A1 | 06-03-2019 |
| | | | WO | 2017186781 A1 | 02-11-2017 |
| US 4510411 | A | 09-04-1985 | JP | H0527348 B2 | 20-04-1993 |
| | | | JP | S59204477 A | 19-11-1984 |
| | | | US | 4510411 A | 09-04-1985 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **SEMNANI et al.** Frequency response of atmospheric pressure gas breakdown in micro/nanogaps. *Applied Physics Letters,* August 2013, vol. 103 (6